# EUROPÄISCHE PATENTSCHRIFT

(11) **EP 2 183 794 B1**
(45) Veröffentlichungstag und Bekanntmachung des Hinweises auf die Patenterteilung: **05.04.2017**
(21) Anmeldenummer: 08801127.5
(22) Anmeldetag: 06.08.2008
(51) Int. Cl.: H01L 33/00, H01R 13/514, H01R 13/717, F21S 2/00

(54) **LED-GEHÄUSE**
LED HOUSING
BOÎTIER DE DEL

(30) Priorität: 30.08.2007 DE 102007041136
(43) Veröffentlichungstag der Anmeldung: 12.05.2010
(73) Patentinhaber: OSRAM Opto Semiconductors GmbH, 93055 Regensburg (DE)
(72) Erfinder: KÖHLER, Steffen, Penang 10250 (MY); GRÖTSCH, Stefan, 93077 Lengfeld-Bad Abbach (DE); BRUNNER, Herbert, 93161 Sinzing (DE); HUBER, Rainer, 93080 Pentling (DE)
(74) Vertreter: Epping - Hermann - Fischer
(86) Internationale Anmeldenummer: PCT/DE2008/001293
(87) Internationale Veröffentlichungsnummer: WO 2009/026876

(56) Entgegenhaltungen:
- EP-A- 1 134 849
- WO-A-2007/069130
- DE-A1- 10 242 292
- DE-U1- 20 311 557
- US-A1- 2006 262 533

## Beschreibung

Die Erfindung betrifft ein LED-Gehäuse mit einer Gehäusekavität, einem Trägerelement, einem LED-Chip, einem Halteelement und zumindest einem Gehäuseanschlusselement, wobei das Gehäuse derart ausgestaltet ist, dass es modular durch ein zweites baugleiches LED-Gehäuse erweiterbar ist. Weiterhin kann das Gehäuse verschiedenartig auf einem Träger montiert werden und weist eine optimale Wärmeableitung auf. Die Druckschrift US2006/0262533 A1 beschreibt eine modulare Leuchtdiode.

Die Druckschrift DE 102 42 292 A1 beschreibt eine Flächenlampe.

Leuchtdioden auch bekannt als Lumineszenzdioden oder Light Emitting Diodes (LEDs) sind optoelektronische Bauelemente, die in ihrem Betrieb elektromagnetische Strahlung mit Wellenlängen im ultravioletten, infraroten aber auch im für das menschliche Auge wahrnehmbaren Teil des elektromagnetischen Spektrums aussenden.

Darüber hinaus weisen sie eine Vielzahl von Einsatzmöglichkeiten auf. Beispielsweise erzeugen typische Hochleistungsleuchtdioden bereits eine Lichtstärke von einigen Watt und sind dadurch als Scheinwerfer oder Projektionsbeleuchtungen geeignet und einsetzbar. Andererseits werden LEDs als Statusanzeigen, Leuchtmittel unterschiedlichster Wellenlänge, Kontrollleuchten, zur Datenübertragung, in Anzeigeelementen und vieles mehr verwendet.

Zur Erzeugung der elektromagnetischen Strahlung nutzen Leuchtdioden in speziellen Halbleitergitterstrukturen insbesondere die Energielücke zwischen Leitungs- und Valenzband. Dabei wird die Differenz zwischen den Energieniveaus des Valenzbandes und des Leitungsbandes als Bandabstand oder Bandlücke verstanden, wobei die Halbleitermaterialien mit direktem Bandübergang der höchste energetische Zustand im Valenzband direkt unterhalb des niedrigsten energetischen Zustandes des Leitungsbandes liegt. Durch Energiezufuhr wechseln Elektronen vom niedrigeren Energiezustand des Valenzbandes in den höheren Energiezustand des Leitungsbandes. Beim Rekombinieren dieser Elektronen in das Valenzband geben die Elektronen diese eingebrachte Energie in Form von elektromagnetischer Strahlung einer bestimmten Wellenlänge ab.

Durch Einbringen eines Lumineszenzkonversionselementes in den Strahlengang des aussendenden Halbleiters ist es möglich, die primär erzeugte Wellenlänge in eine Sekundärwellenlänge zu konvertieren. Somit ist es möglich, auf einfache Art Mischlicht, beispielsweise Weißlicht oder Licht einer speziellen Wellenlänge, zu generieren, die nicht dem Bandabstand des jeweiligen Halbleiters entspricht.

Eine Leuchtdiode kann nun auf unterschiedliche Art montiert werden. Zum einen können LEDs durch Surface-Mount Technology (SMT - Oberflächenmontagetechnologie) auf einer Leiterplatte montiert sein. Diese Platz sparende Variante erspart in Spezialformen zusätzliche Anschlussbeine, da der elektrische Anschluss in Form eines Pads oder einer elektrisch leitenden Platte an einer Außenseite des Gehäuses angebracht sein kann und eine elektrische Verbindung zu dem Halbleiterchip im Inneren des Gehäuses aufweist.

Eine weitere Variante zur Montage von Leuchtdioden ist die Ausführung des LED-Gehäuses mit Anschlussbeinen, zur Montage auf einer gelochten Leiterplatte. Dazu müssen die für den elektrischen Betrieb vorgesehenen Anschlüsse speziell ausgestaltet sein. Hierbei wird ein Leuchtdioden-Chip in ein Gehäuse, vorzugsweise ein teilweise für die emittierende Wellenlänge transparentes Vergussmaterial, eingebracht. Der elektrische Anschluss des emittierenden Chips erfolgt nun über diskrete, aus dem Gehäuse herausgeführte zusätzliche Anschlussbeine.

Für den Fall, dass Leuchtdioden nicht direkt auf Leiterplatten montiert werden, da sie möglicherweise in relativ weiter Entfernung zu diesen eingesetzt werden, wie beispielsweise in Gerätefronten oder im Einsatz in einer primitiven Anwendung, in welcher der Entwurf einer Leiterplatte nicht zweckmäßig wäre, gibt es LED-Zusatzelemente, beispielsweise Fassungsadapterstücke, die eine herkömmliche LED mittels Stecksystemen und/oder Halterungen elektrisch und/oder mechanisch verbinden.

Um die Leuchtkraft für eine Anwendung zu erhöhen, werden beispielsweise mehrere Leuchtdioden zusammen auf einer Leiterkarte platziert und montiert. Auf dem Gebiet der Projektionstechnik werden beispielsweise Hintergrundbeleuchtungen für Flüssigkristallbildschirme, auch Liquid Crystal Displays (LCD) mittels Weißlicht-LED Matrix erzeugt, wobei eine Matrix aus einer Vielzahl von Weißlicht-LEDs als Hintergrundbeleuchtung dient.

Nachteil aller dieser Techniken ist, dass zusätzliche Elemente, wie Anschlusselemente im Allgemeinen oder Adapterstücke benötigt werden, um eine Leuchtdiode zu betreiben. Hinzu kommt der Nachteil, dass eine LED, die für eine spezielle Montageart gefertigt wurde, nur bedingt für weitere Montagemethoden eingesetzt werden kann. Schließlich ist ein Verbund von LEDs ebenfalls nur über zusätzliche Elemente realisierbar. Dadurch kommt es zu Verlusten durch zusätzliche Wärmeentwicklung und einen höheren Platzbedarf.

Der Erfindung liegt somit die Aufgabe zugrunde, ein LED-Gehäuse vorzusehen, welches auf verschiedene Arten montierbar ist und darüber hinaus modular mit einem weiteren baugleichen LED-Gehäuse erweiterbar ist.

Diese Aufgabe wird unter anderem mit dem Gegenstand des im Patentanspruch 1 beschriebenen LED-Gehäuses erreicht.

Hierbei wird ein LED-Gehäuse, welches eine Gehäusekavität, ein Trägerelement, mindestens einen LED-Chip, mindestens ein Halteelement und zumindest ein Gehäuseanschlusselement aufweist, aufgezeigt. Dabei ist das Trägerelement auf einer ersten Oberseite mit zumindest einem LED-Chip bestückt und innerhalb der Gehäusekavität im LED-Gehäuse angeordnet. Weiterhin ist das LED-Gehäuse derart ausgeformt, dass das zumindest eine Gehäuseanschlusselement an einer Außenseite des LED-Gehäuses angeordnet ist und eine elektrische Verbindung zu dem mindestens einen LED-Chip zum Betreiben dieses LED-Chips aufweist und weiterhin das LED-Gehäuse mechanisch bedingt lösbar mit einem zweiten baugleichen LED-Gehäuse verbindbar ist.

"Mechanisch bedingt lösbar" kann dabei heißen, dass die Verbindung aufgrund mechanischer Krafteinwirkung lösbar ist. Wobei die Verbindung vorzugsweise zerstörungsfrei lösbar ist, so dass nach dem Lösen zweier baugleicher LED-Gehäuse voneinander zumindest eines der LED-Gehäuse wieder verwendet werden kann.

Durch den beschriebenen Gegenstand wird ein LED-Gehäuse geschaffen, welches flexibel für unterschiedlichste Montagevarianten einsetzbar, flexibel elektrisch verbindbar ist und darüber hinaus ohne zusätzliche Elemente mit einem weiteren baugleichen LED-Gehäuse mechanisch verbindbar beziehungsweise erweiterbar ist.

Gemäß der Erfindung ist das LED-Gehäuse mechanisch bedingt lösbar mittels zumindest eines Halteelements mit einem Träger mechanisch verbindbar. Ein Träger im Sinne der Erfindung ist beispielsweise ein Kühlkörper, eine Platine oder allgemein eine Wärmesenke. Als Träger allgemein lässt sich ein Basiskörper beschreiben, der dem LED-Gehäuse genug Haltekraft in seiner spezifischen Anwendung bietet. Durch Ausgestalten des LED-Gehäuses in dieser universellen Form ist es möglich, auf Basis lediglich einer charakteristischen LED-Gehäuseform mehrere Montagemethoden einer Leuchtdiode zu realisieren, ohne zusätzliche Elemente zu benötigen.

Ist der Träger in einer speziellen Ausgestaltung eine Wärmesenke, so sorgt er durch seine guten Wärmeleiteigenschaften für einen ausreichend hohen Wärmeabtransport und verhindert dadurch ein Zerstören des LED-Chips innerhalb der Gehäusekavität.

Eine ausreichende Haltekraft für die mechanische Verbindung mit dem Träger wird hierbei durch zumindest ein Halteelement erreicht. Das Halteelement ist entweder ein Teil des LED-Gehäuses oder als zusätzliches Element an dem LED-Gehäuse befestigt. Ein Halteelement ist hierbei ein in das LED-Gehäuse eingebrachtes Loch, durch welches ein mechanisches Verbindeelement, zum Beispiel eine Schraube oder ein Haltestift, geführt ist. Das Halteelement ist dabei entweder als separates Element am LED-Gehäuse angebracht oder als Teil des Gehäuses geformt.

In einer weiteren vorteilhaften Ausgestaltung weist das LED-Gehäuse eine mechanische und/oder elektrische Verbindung zu einem baugleichen LED-Gehäuse durch zumindest ein Haltelement auf. Hierdurch wird eine stabile mechanische Verbindungskraft sowie eine elektrische leitende Verbindung zwischen zwei LED-Gehäusen geschaffen, ohne weitere zusätzliche Elemente, beispielsweise Trägerelemente, zu benötigen.

In einer weiteren vorteilhaften Ausgestaltung weist das LED-Gehäuse zusätzlich ein Wärmeableitelement auf, welches sich zumindest an einer zweiten Seite des Trägerelementes befindet. Diese zweite Seite ist der ersten Oberseite des Trägerelements gegenüberliegend. Durch dieses Wärmeableitelement wird ein verbesserter Wärmeabtransport, vom Inneren der Gehäusekavität nach Außen erreicht, wodurch beispielsweise Hochleistungsleuchtdiodenchips vor einer Überhitzung und somit drohender Zerstörung geschützt sind.

In vorteilhafter Weise ist das Halteelement mehrteilig und das Gehäuseanschlusselement in zumindest einem Teil des Halteelements integriert. Dadurch ist ein universelles modulares Erweitern zu einem baugleichen LED-Gehäuse oder einem Träger möglich, wobei zumindest ein Teil des Halteelements ebenfalls die elektrische Verbindung zwischen den LED-Chips bereitstellt. Weiterhin wird die mechanische Verbindungskraft zu einem Träger oder einem zweiten LED-Gehäuses durch das Halteelement erzeugt. Im Idealfall ist das Halteelement dann einteilig und erzeugt somit beispielsweise durch ein Stecksystem die elektrische und mechanische Verbindung. Durch diese Maßnahme ist ein schnelles Erweitern eines LED-Gehäuses erreicht.

In einer weiteren vorteilhaften Ausgestaltung weist das Gehäuseanschlusselement zumindest ein Anodenanschlusselement und ein Kathodenanschlusselement auf. Diese beiden Anschlusselemente können in vorteilhafter Weise als mechanisches und/oder elektrisches Stecksystem ausgebildet sein, wobei das Anodenanschlusselement beispielsweise eine Buchse und das Kathodenanschlusselement beispielsweise einen Stecker oder umgekehrt darstellt. Durch diese Ausgestaltung ist es sehr einfach möglich, ein LED-Gehäuse mit einem zusätzlichen LED-Gehäuse zu erweitern oder ein LED-Gehäuse mit einem Träger zu verbinden. Dadurch ist es möglich, ohne zusätzliche Elemente eine Steigerung der Lichtintensität zu erhalten. Weiterhin ist es dadurch einfach möglich, eine zusätzliche Farbe in eine LED-Gehäuseanordnung einzubringen. Durch ein einfaches Steckprinzip kann so ein vielfarbiges und leuchtstarkes LED-Gebilde geschaffen werden. Hierbei werden dann zur möglichen Reihenschaltung von LED der Kathodenanschluss des ersten LED-Gehäuses mit dem Anodenanschluss des zweiten LED-Gehäuses verbunden.

In einer weiteren vorteilhaften Ausgestaltung weist die Gehäusekavität des LED-Gehäuses eine Mehrzahl an LED-Chips auf. Diese LED-Chips sind in der ersten Ausgestaltungsform in Reihe geschaltet, wobei jeder Anodenanschluss eines LED-Chips mit einem Kathodenanschluss eines benachbarten LED-Chips verbunden ist. Ein erster Anodenanschluss, welcher als gemeinsamer Anodenanschluss des LED-Gehäuses dient und ein letzter Kathodenanschluss, welcher als gemeinsamer Kathodenanschluss des LED-Gehäuses dient, werden zu dem Gehäuseanschlusselement des LED-Gehäuses geführt. Somit werden alle LED-Chips innerhalb dieses LED-Gehäuses über ein gemeinsames, in spezieller Form mehrteiliges, Gehäuseanschlusselement elektrisch ansteuerbar. In dieser Ausgestaltung erhöht sich bereits die ausgestrahlte Lichtstärke eines einzelnen LED-Gehäuses immens. Des Weiteren ist es möglich, Mischfarben innerhalb eines LED-Gehäuses zu erzeugen, wobei jeder LED-Chip eine bestimmte Wellenlänge emittiert, im Beispiel einer Mischlampe wäre zum Beispiel ein Weißlicht erzeugbar, was durch die Farbkombination rot, grün und blau sehr einfach möglich ist.

In einer weiteren vorteilhaften Ausgestaltung ist das Gehäuseanschlusselement über Steckverbinder beziehungsweise Rastverbinder elektrisch ansteuerbar, wobei das LED-Gehäuse grundsätzlich SMT-montiert ist. In dieser Ausgestaltung ist eine gute Wärmeableitung zur SMT Platine geschaffen, auf der wiederum zusätzlich eine Wärmesenke, beispielsweise in Form eines Kühlkörpers vorhanden sein kann. Weiterhin ist dadurch ein flexibles elektrisches Verbinden des LED-Gehäuses erreicht. In einer Weiterführung dieser Ausführungsform ist auch das Gehäuseanschlusselement SMT-montiert, wodurch die elektrische Verbindung ebenfalls über die SMT-Platine erfolgt. Gleiches gilt selbstverständlich für andere Montageformen.

In einer vorteilhaften Ausgestaltung ist am LED-Gehäuse zusätzlich ein Steueranschlusselement angebracht. Dieses Steueranschlusselement weist eine elektrische Verbindung zu zumindest einem Steuerelement innerhalb der Gehäusekavität auf. Dieses Steuerelement steuert wiederum die Intensität der ausgesendeten elektromagnetischen Strahlung eines der LED-Chips innerhalb der Gehäusekavität. Durch Ausführen in dieser Form ist es möglich, jeden einzelnen LED-Chip separat auszusteuern und beispielsweise mittels eines pulsweiten modulierten (PWM) Signals eine bestimmte Farbeinstellung oder individuelle Lichtintensität pro LED-Gehäuse vorzunehmen.

In einer weiteren vorteilhaften Ausgestaltung werden die Anschlüsse jedes LED-Chips einzeln zum Gehäuseanschlusselement geführt. Hierdurch ist jeder LED-Chip separat ansteuerbar und somit ein- und ausschaltbar. In dieser Ausgestaltung ist es möglich, in einem LED-Gehäuse jeden der LED-Chips unabhängig von den anderen LED-Chips anzusteuern sowie an- und abzuschalten.

In einer vorteilhaften Ausgestaltung der Erfindung ist das Trägerelement ein Direct-Bonded-Copper Keramiksubstrat (DBC-Keramik). Durch diese Substratart, die ein "Sandwichaufbau" aus Kupfer-Keramik-Kupfer ist, erfolgt eine elektrische Isolation. Weiterhin wird durch diese Substratart eine lateral gespreizte Wärmeabfuhr erzeugt, wodurch eine gute Wärmeableitung erfolgt. Zusätzlich ist dieses Substrat elektrisch sehr gut leitend.

In einer weiteren vorteilhaften Ausgestaltung ist das Trägersubstrat ein metallischer Träger, zum Beispiel Kupfer oder Kupferlegierung mit Bondmetallisierung. Für diesen Fall müssen die LED-Chiprückseiten elektrisch isolierend ausgestaltet sein.

Der Anschluss der LED-Chips mit dem Gehäuseanschlusselement erfolgt vorzugsweise durch Laserschweiß- und/oder Bondverfahren. Auf diese Weise ist eine schnellere Fertigung erreichbar.

In einer weiteren vorteilhaften Ausgestaltung weist das LED-Gehäuse zusätzlich ein optisches Element, beziehungsweise Halterungen für ein solches optisches Element auf, beispielsweise eine Linse oder eine linsenartige Verkappung. Durch dieses optische Element ist eine Strahlbündelung, Strahlaufweitung beziehungsweise allgemein eine Strahlablenkung erreichbar. Dadurch ist eine gezielte Abstrahlcharakteristik der LED erzielt.

In einer weiteren vorteilhaften Ausgestaltung ist das LED-Gehäuse aus einem Vergussmassematerial. Dieses Vergussmassematerial ist während des Herstellungsprozesses flüssig und wird durch Passformung zur gewünschten LED-Gehäuseform geformt.

In einer weiteren vorteilhaften Ausgestaltung ist zumindest ein Teil des Halteelements separat oder mit den Gehäuseanschlusselementen standardisiert ausgeformt. Durch die standardisierte Formgebung, wie sie in vielen Bereichen, beispielsweise im Kfz-Bereich, vorzufinden ist, wird ein größtmöglicher Einsatzbereich dieses LED-Gehäuses ermöglicht.

Das erfindungsgemäße elektrische und/oder mechanische in Reihe Verbinden mehrerer LED-Gehäuse erfolgt beispielsweise durch Stecken, Rasten, oder auch Schrauben. Weiterhin ist auch eine Parallelschaltung dieser LED-Gehäuse denkbar, was durch ein zusätzliches Adapterstück erreichbar ist. Dieses Adapterstück wird beispielsweise zwischen zwei Anodenanschlusselementen angebracht und dient der elektrischen Überbrückung. Weiterhin dient das Adapterstücks als Abstandshalter zwischen den parallel verbundenen LED-Gehäusen.

Wird jeder LED-Chipanschluss zum LED-Gehäuseanschlusselement separat geführt ist ein zusätzlicher Brückenadapter ebenfalls im Umfang der Erfindung enthalten. Dieser Brückenadapter dient der Reihenschaltung der LED-Chips außerhalb des LED-Gehäuses, falls diese nicht für eine Verbindung mit weiteren LED-Gehäusen vorgesehen sind.

Nachfolgend wird die Erfindung anhand von Ausführungsbeispielen mit Bezugnahme auf die Zeichnung erläutert, wobei die Figuren gleiche oder gleich wirkende Bestandteile jeweils mit gleichen Bezugszeichen gekennzeichnet sind. Die dargestellten Elemente sind nicht als maßstabsgerecht anzusehen, vielmehr können einzelne Elemente zum besseren Verständnis übertrieben groß oder übertrieben vereinfacht dargestellt sein.

Es zeigen:
- Figur 1: in a) einen Schnitt durch ein schematisch dargestelltes Ausführungsbeispiel eines LED-Gehäuses und in b) eine Draufsicht auf das in a) dargestellten Ausführungsbeispiel,
- Figur 2: eine Weiterbildung der in Figur 1 dargestellten Ausführungsform des LED-Gehäuses,
- Figur 3: eine alternative Ausführungsform zur in Figur 1 dargestellten Ausführungsform des LED-Gehäuses,
- Figur 4: eine Weiterbildung der in Figur 3 dargestellten Ausführungsform des LED-Gehäuses,
- Figur 5: eine Ausführungsform des LED-Gehäuses in 3D-Darstellung in verschiedenen Weiterbildungen a-d,
- Figur 6: eine Weiterbildung der in Figur 2 dargestellten Ausführungsform des LED-Gehäuses,
- Figur 7: eine Weiterbildung der in Figur 6 dargestellten Ausführungsform des LED-Gehäuses,
- Figur 8: eine Reihenschaltung aus drei, einer der dargestellten Ausführungsformen und/oder Weiterbildungen des LED-Gehäuses,
- Figur 9: eine Reihen- und Parallelschaltung aus acht, einer der dargestellten Ausführungsformen und/oder Weiterbildungen des LED-Gehäuses,
- Figur 10: eine alternative Verschaltungsvariante einer der in Figur 6 dargestellten Ausführungsform des LED-Gehäuses.

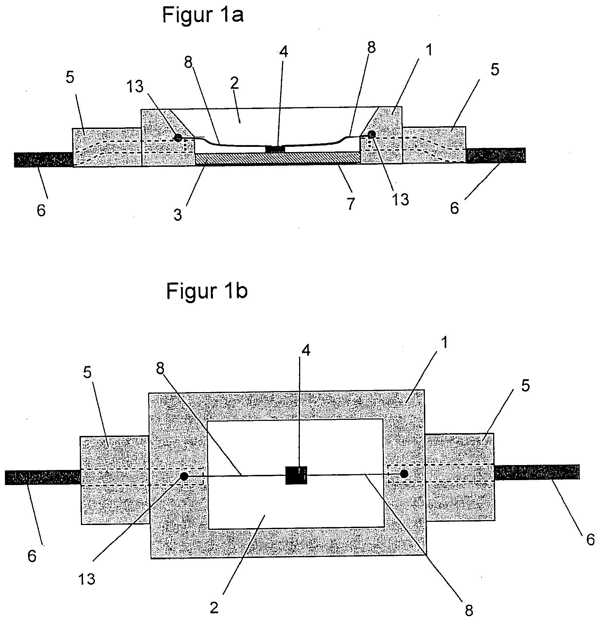

In Figur 1a ist ein Querschnitt einer schematischen Darstellung eines Ausführungsbeispiels eines LED-Gehäuses aufgezeigt. Das LED-Gehäuse 1 weist eine Gehäusekavität 2 auf. Innerhalb der Gehäusekavität 2 befindet sich ein Trägerelement 3, auf dessen einer Oberseite ein LED-Chip 4 angeordnet ist. Auf der der Oberseite gegenüberliegenden Seite ist ein Wärmeleitelement 7 angeordnet. Das LED-Gehäuse 1 weist weiterhin Halteelemente 5 und Gehäuseanschlusselemente 6 auf, die sich an zwei Außenseiten des LED-Gehäuses 1 befinden. Die Gehäuseanschlusselemente 6 wiederum weisen eine elektrische Verbindung 8 zum LED-Chip 4 auf, wobei eine Bondverbindung 13 die elektrische Verbindung 8, beispielsweise mittels Bonddraht realisiert, auf das Gehäuseanschlusselement 6 verbindet.

Mittels der Haltelemente 5 und der Gehäuseanschlusselemente 6 ist das LED-Gehäuse 1 beliebig auf einem Träger montierbar. Hierbei kann jedes Halteelement 5 als Teil des LED-Gehäuses 1 ausgebildet sein, beziehungsweise als separates Element am LED-Gehäuse 1 während eines Fertigungsprozesses angebracht werden.

In Figur 1b ist eine Draufsicht des in Figur 1a dargestellten LED-Gehäuses 1 gezeigt. Wie zu erkennen ist, ist das LED-Gehäuse sowohl elektrisch, als auch mechanisch durch SMT montierbar. Dabei werden insbesondere die Gehäuseanschlusselemente mittels Lötverfahren mit einer Ansteuerschaltung verbunden. In dieser Ausführungsform ist es weiterhin möglich, eine Steckverbindung mit jedem Gehäuseanschlusselement 6 über ein Stecksystem herzustellen. Ein nicht dargestelltes Gegenstück ist durch geeignete Formgebung mit dem Halteelement 5 und dem Gehäuseanschlusselement 6 verbindbar, wobei das Halteelement 5 zusätzliche Haltekraft erzeugt. Durch dieses Gegenstück ist weiterhin eine Platinenmontage denkbar, ohne eine Lötverbindung zu benötigen. Darüber hinaus können die Gehäuseanschlusselemente gleicher LED-Gehäuse 1 mittels dieses Gegenstücks miteinander verbunden werden.

Das Wärmeableitelement 7 dient insbesondere bei Hochleistungs-LEDs zum verbesserten Wärmeabtransport aus dem Innern des LED-Gehäuses 1 und schützt den LED-Chip 4 vor Überhitzung und Zerstörung. In vorteilhafter Weise wird das LED-Gehäuse 1 auf eine Wärmesenke montiert, wodurch der Wärmeabtransport wesentlich verbessert werden kann.

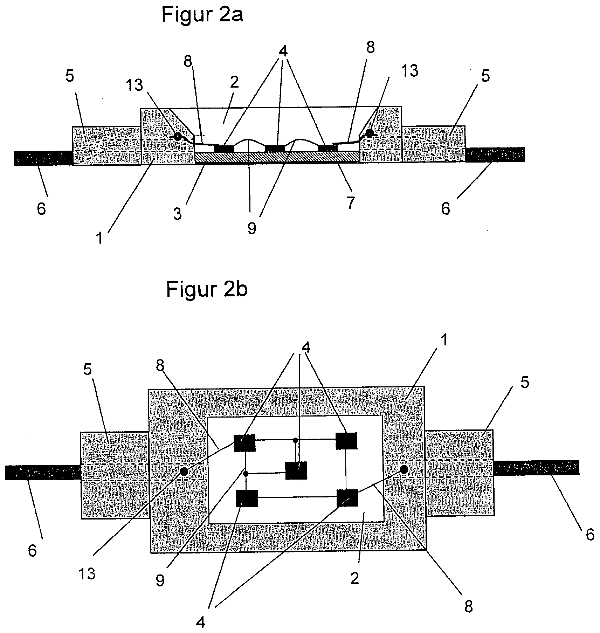

Figur 2 zeigt eine Weiterbildung der in Figur 1 dargestellten Ausführungsform des LED-Gehäuses. Der Aufbau ist prinzipiell vergleichbar mit dem Ausführungsbeispiel aus Figur 1, wodurch hier nur auf die Unterschiede zur Figur 1 aufgezeigten Ausführungsform eingegangen wird. Unterschiedlich zu Figur 1 ist eine Reihenschaltung von mehreren LED-Chips 4 in die Gehäusekavität 2 eingebracht. Das Gehäuseanschlusselement 6 weist eine elektrische Verbindung 8 zu einem der LED-Chips 4 auf, wobei die LED-Chips 4 untereinander in Reihe verschaltet sind. Dazu werden alle Anodenanschlüsse eines LED-Chips 4 mit einem Kathodenanschluss des nächsten in der Kavität 2 befindlichen LED-Chips 4 mittels Bondzwischenverbindung 9 verbunden. Lediglich der Anodenanschluss des ersten LED-Chips 4 der Reihenschaltung sowie der Kathodenanschluss des letzten LED-Chips 4 der Reihenschaltung werden nicht verbunden, sondern jeweils elektrisch mit den Gehäuseanschlusselementen 6 mittels Bondverbindung 13 verbunden.

Eine Verdeutlichtung der Reihenschaltung der LED-Chips 4 ist in Figur 2b aufgezeigt. Schematisch dargestellt werden die LED-Chips 4 mit zwei Anschlüssen, einem Anoden- und einem Kathodenanschluss, wobei jeweils ein Kathodenanschluss mit dem Anodenanschluss eines benachbarten LED-Chips mittels Bondzwischenverbindung 9 verbunden ist. Der erste Anodenanschluss sowie der letzte Kathodenanschluss sind jeweils mit einem Gehäuseanschlusselement 6 verbunden. Dies geschieht wiederum über elektrische Verbindungen 8 und der Bondverbindung 13.

Vorteil dieser Weiterbildung ist eine Erhöhung der Leuchtintensität eines LED-Gehäuses 1 allgemein. Durch eine Vielzahl von LED-Chips 4 ist eine Vervielfachung der emittierten Lichtstärke möglich. Ein Ansteuern der reihengeschalteten LED-Chips 4 erfolgt hier wiederum über die Gehäuseanschlusselemente 6. Vergleichbar mit der Ausführungsform der Figur 1 weisen die Halteelemente 5 in Verbindung mit den Gehäuseanschlusselementen 6 mehrere Möglichkeiten auf, das LED-Gehäuse 1 zu montieren.

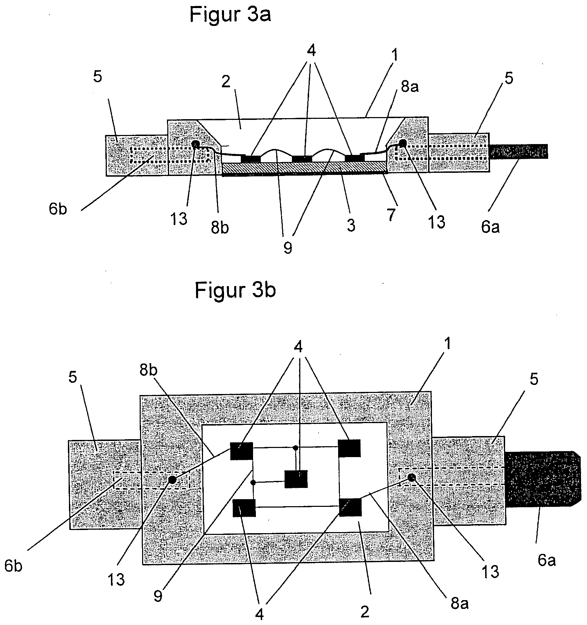

In Figur 3 ist eine alternative Ausführungsform zur in Figur 1 dargestellten Ausführungsform des LED-Gehäuses aufgezeigt. Durch die starke Ähnlichkeit zu den bereits beschriebenen Figuren 1 und 2 wird hier nur auf die charakteristischen Unterschiede zu diesen Figuren eingegangen. Anders als in Figur 1 weist das Gehäuseanschlusselement 6 nun zwei verschiedene Formen auf, wobei jede Form ein spezieller Anschlusstyp ist. Dabei ist der erste Anodenanschluss 8a mit einem Anodenanschlusselement 6a und der letzte Kathodenanschluss mit einem Kathodenanschlusselement 6b elektrisch verbunden.

Das Gehäuseanschlusselement 6, ausgeführt als Anodenanschlusselement 6a und Kathodenanschlusselement 6b, bildet ein universelles Stecksystem. Das Anodenanschlusselement 6a weist hierbei die Funktion eines Steckers und das Kathodenanschlusselement 6b hierbei die Funktion einer Buchse auf. Eine Ausführung von Stecker und Buchse, entgegengesetzt zur beschriebenen Variante, ist ebenfalls möglich. Durch dieses Stecksystem ist eine problemlose Aneinanderreihung mehrere LED-Gehäuse möglich.

In vorteilhafter Weise ist dieses Stecksystem standardisiert und entspricht einer Norm. Somit kann dieses LED-Gehäuse problemlos in ein bestehendes Stecksystem integriert werden, beispielsweise im Kfz-, Elektronik- oder Gerätebereich. Dadurch, dass das Halteelement als Teil des Gehäuses bereits mitgefertigt wird, ist kein zusätzliches Gegenstück oder Zusatzfassung erforderlich und das LED-Gehäuse universell einsetzbar. Es werden dadurch zusätzliche Kosten gespart und Übergangsverluste, die bei Adaptern als Nebeneffekt stets vorhanden sind, umgangen.

Vergleichbar zu Figur 1 und 2 wird ein ausreichender Wärmeabtransport, speziell für Hochleistungs-LEDs, durch das Wärmeableitelement 7 erreicht. Ein entsprechender elektrischer und/oder mechanischer Anschluss an die Anschlusselemente 6a und 6b kann wiederum auch über Stecksysteme, Rastsysteme oder Schraubsysteme vorzugsweise standardisiert erfolgen.

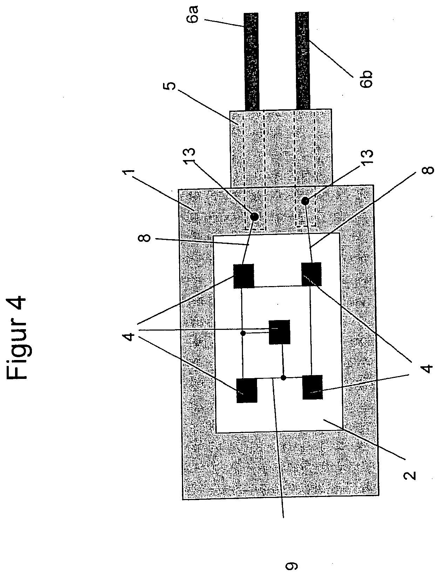

In Figur 4 ist eine Weiterbildung der in Figur 3 dargestellten Ausführungsform des LED-Gehäuses aufgezeigt, wobei hier auf die Schnittdarstellung verzichtet wird. Im Folgenden wird wiederum lediglich auf die Unterschiede gegenüber Figur 3 eingegangen. Im Unterschied zu den vorangegangenen Figuren ist in Figur 4 lediglich ein Halteelement 5 dargestellt, welches der Verbindung mehrerer LED-Gehäuse beziehungsweise mit einem Träger dient. Mittels eines Steckers beispielsweise ist die dargestellte Ausgestaltungsform mit einem Träger elektrisch kontaktierbar aber auch mit anderen LED-Gehäusen 1 verbindbar. Ebenfalls sind Kathodenanschluss- und Anodenanschlusselement 6a und 6b getrennt ausgeführt. Bevorzugt wird diese Variante zur Montage in einer gelochten Leiterplatte verwendet, beziehungsweise auf einem Träger montiert beziehungsweise gesteckt.

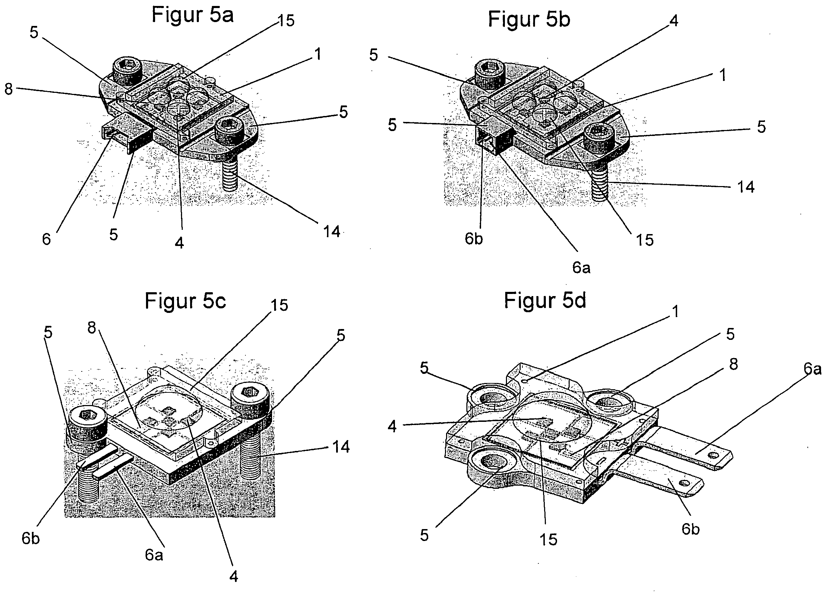

Figur 5 zeigt vier Weiterbildungen einer alternativen Ausführungsform der in Figur 1 dargestellten Ausführungsform des LED-Gehäuses als 3D-Skizzen. Unterschiedlich zu Figur 1 ist, dass das Halteelement beispielsweise mehrteilig ausgestaltet sein kann. Die Halteelemente 5 in Figur 5a sind beispielsweise Schraubenhalterungen und Steckergegenstück. Somit wird zum einen eine mechanische Haltekraft mit einem Träger ermöglicht, allerdings auch eine Haltekraft eines nicht dargestellten passgenauen Gegenstücks des Gehäuseanschlusselementes für eine elektrisch leitende Verbindung.

Weiterhin weist das LED-Gehäuse 1 in Figur 5a ein optisches Element 15 auf, welches zur Strahlenablenkung der ausgesendeten elektromagnetischen Strahlung hier eines jeden LED-Chips 4 dient. Dadurch ist eine optimale Abstrahlcharakteristik für das jeweilige LED-Gehäuse in Bezug auf die jeweilige Anwendung erreicht. Als Verbindungselemente 14 sind hierbei Schrauben vorgesehen. Diese dienen vorrangig der mechanischen Verbindung mit einem Träger, insbesondere einer Wärmesenke. Andere Verbindungselemente sind ebenfalls denkbar und vom Erfindungsgedanken nicht ausgeschlossen.

Die Figuren 5b bis 5d weisen grundsätzlich ähnliche Elemente auf. Unterschiedlich ist beispielsweise die Form des optischen Elementes, welches in Figuren 5c und 5d als ein Element für alle LED-Chips 4 ausgeführt ist. Weiterhin sind die Gehäuseanschlusselemente 6, 6a, 6b verschieden ausgeführt, wobei in Figur 5d eine bereits erwähnte standardisierte elektrische Verbindung, beispielsweise für den Kfz-Bereich, vorgesehen ist. Hingegen ist in Figur 5c eine Ausführungsvariante für ein alternatives System erkennbar.

Die aufgezeigten Löcher in den Figuren 5a bis 5d sind hierbei Halteelemente 5 und machen deutlich, dass das Haltelement 5 als Teil des LED-Gehäuses 1 sehr einfach herstellbar ist. Zusätzlich kann das Halteelement aus mehreren Teilen bestehen, wobei ein Teil der Halterungen mittels Schraubverbindung an einem Träger befestigt sind. Allerdings kann das Halteelement 5 andere Teile 5 zur gesicherten Verbindung zu einem anderen LED-Gehäuse beziehungsweise einer Platine oder einer Wärmesenke aufweisen.

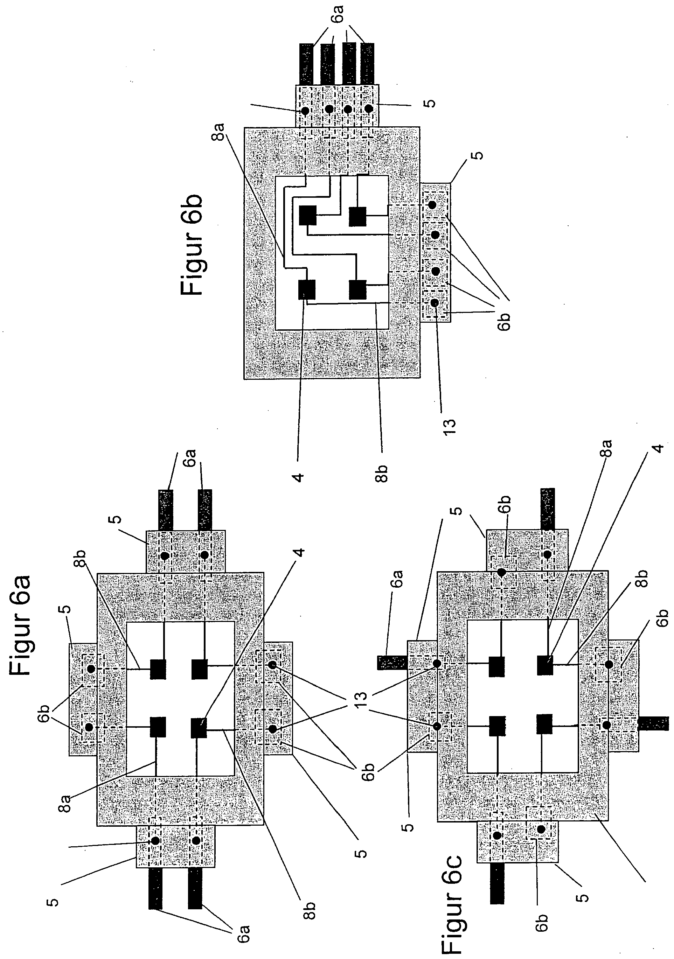

In Figuren 6a, 6b und 6c werden Weiterbildungen der in Figur 2 dargestellten Ausführungsform des LED-Gehäuses aufgezeigt. Unterschiedlich zu Figur 2 ist hierbei, dass jede LED individuell ansteuerbar ist. Figur 6c wiederum zeigt hierbei eine Variante, bei der jedes Halteelement 5 ein Kathodenanschlusselement 6b und Anodenanschlusselement 6a aufweist. Mittels eines universellen Stecksystems, erreicht durch eine spezielle Formgebung des Halteelements 5, ist eine Erweiterung des LED-Gehäuses mit einem baugleichen LED-Gehäuse oder die Anordnung auf einem Träger auf einfache Weise möglich.

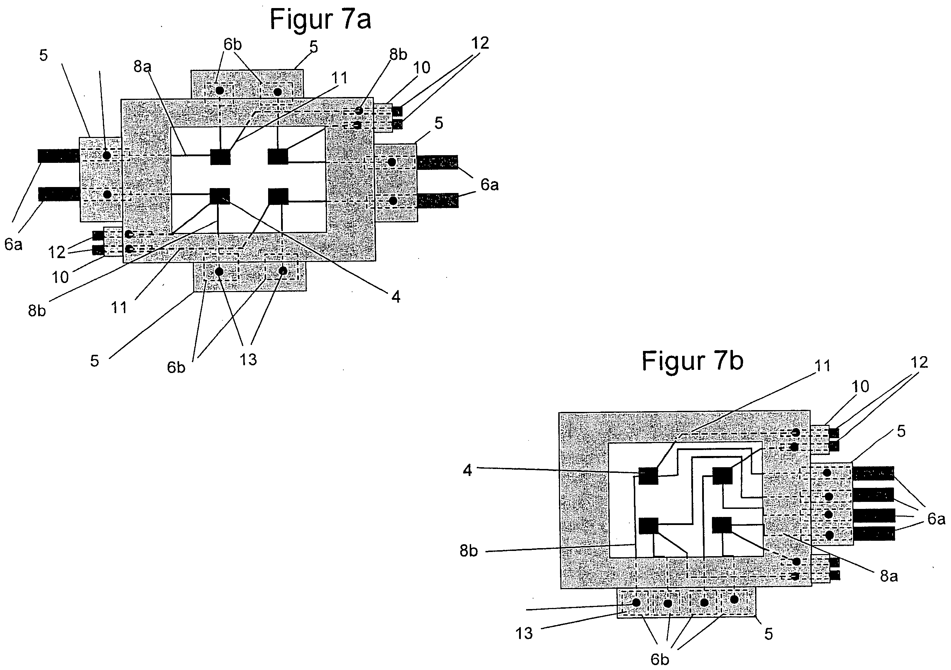

In Figur 7 werden Weiterbildungen der in Figur 6 dargestellten Ausführungsform des LED-Gehäuses aufgezeigt. Im Unterschied zu den vorangegangenen Figuren weisen die LED-Chips 4 in Figur 7 ein nicht dargestelltes Steuerelement auf, welches über ein Steueranschlusselement 10 und einer Steueranschlussverbindung 11 ansteuerbar ist.

Durch diese Weiterbildungen ist es möglich, jeden LED-Chip einzeln, bevorzugt die Intensität des auszustrahlenden elektromagnetischen Lichtes, zu steuern. Durch Ansteuerung mittels pulsweiten modulierten Signalen beispielsweise ist eine individuelle Farbsättigung oder Lichtintensität eines jeden LED-Chips erreichbar.

Die Steueranschlusselemente 10 sind ebenso wie die Halteelemente 5 und Gehäuseanschlusselemente 6, 6a und 6b in ihrer Form frei gestaltbar und in bevorzugter Art standardisiert, um ein flexibles und schnelles Erweitern mit anderen LED-Gehäusen, ein elektrisches Verbinden oder Ansteuern zu ermöglichen. Gleiches gilt für die Montagevarianten mit einem Träger.

Die Verbindung der LED-Chips 4 aus Figur 1 bis 7 untereinander erfolgt bevorzugt mittels Bondzwischenverbindung, wobei das Trägerelement zusätzlich ebenfalls nicht dargestellte Leiterstrukturen aufweisen kann. Eine Verbindung der Anschlusselemente 6, 6a und 6b mit den jeweiligen LED-Chipanschlüssen 8, 8a und 8b erfolgt bevorzugt mittels Laserschweißverfahren oder klassischem Wirebondverfahren.

Als Trägerelement 3 ist bevorzugt ein DBC-Keramiksubstrat zu verwenden, da es durch seinen speziellen "Sandwichaufbau" (Kupfer - Keramik - Kupfer) elektrisch isolierend wirkt und eine lateral gespreizte Wärmeabfuhr ermöglicht, was dieses Substrat zu einem guten thermischen Leiter macht.

Bei Verwendung anderer, insbesondere elektrisch nicht isolierender Trägerelemente 3, müssen die LED-Chipseiten, mit denen der LED-Chip 4 auf dem Trägerelement 3 befestigt ist, elektrisch isolierend beschaffen sein.

Als Material für das LED-Gehäuse sind vorrangig Kunststoffe, beispielsweise PPA, LCP, PEEK oder PEI zu verwenden. Das Trägerelement ist insbesondere ein DBC, MKP-PCB oder AIN-Keramik-Substrat. Ebenfalls sind metallische Träger, beispielsweise Kupfer oder Kupferlegierung mit Bondmetallisierung anwendbar. Im Falle eines nicht isolierenden Trägers müssen die LED-Chip Rückseiten isolierend sein.

Die in Figur 1 bis 7 dargestellten Ausführungsformen beziehungsweise deren Weiterbildungen des LED-Gehäuses sind frei kombinierbar und austauschbar.

Eine weitere Aufgabe des Haltelementes 5 ist die Funktion als Abstandshalter für die Verwendung eines gemeinsamen Trägers durch zwei baugleiche LED-Gehäuse. In diesem Fall ist es wichtig, dass genügend Abstand zwischen den einzelnen LED-Gehäusen vorhanden ist, damit ein genügender Wärmeabtransport gewährleistet ist.

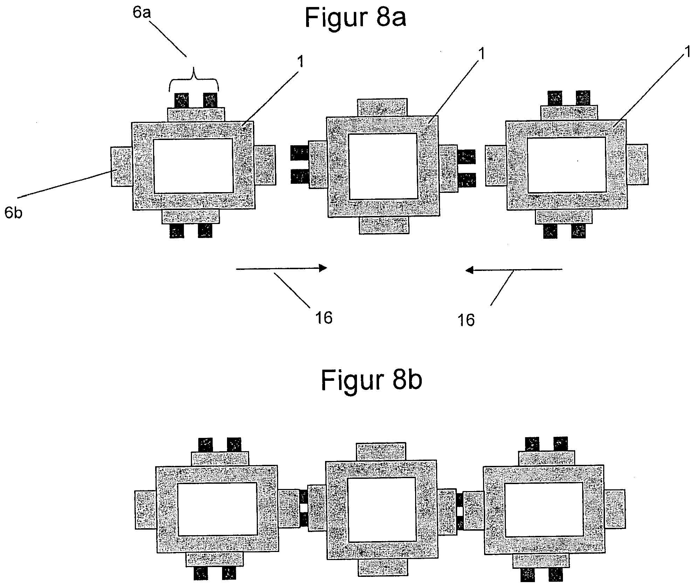

Figur 8 zeigt nun eine Reihenschaltung von drei zusammengesteckten LED-Gehäusen 1. Die LED-Gehäuse 1 sind dabei nach einer der Ausführungsformen und/oder Weiterbildungen der Figuren 1 - 7 gestaltet. Sie weisen sowohl ein Kathodenanschlusselement 6b als auch ein Anodenanschlusselement 6a auf und werden in einem Zusammensteckverfahren 16, wie in Figur 8b dargestellt, verbunden. Die hier nicht gezeigten LED-Chips sind durch eine der in Figur 1 bis 7 beschriebenen Ausgestaltungsvarianten verbunden und mittels Anodenanschlusselement 6a oder Kathodenanschlusselement 6b elektrisch und/oder mechanisch verknüpft. Zusätzlich ist darüber hinaus eine Montage auf einem Träger mittels weiterer bereits beschriebener Halteelemente 5 denkbar.

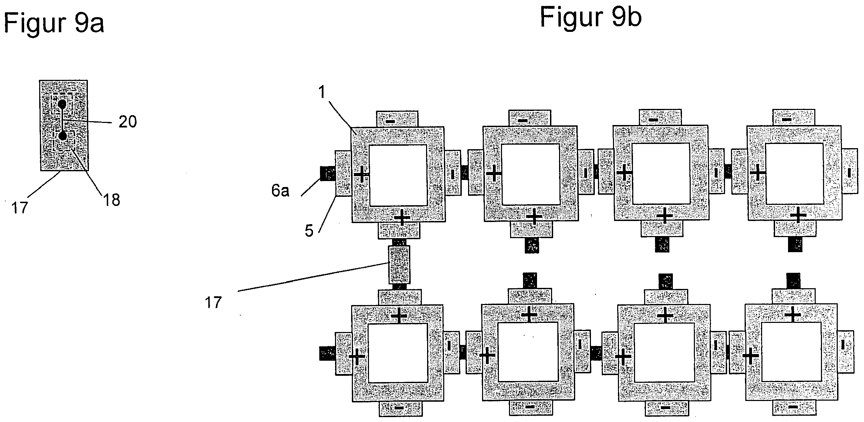

Figur 9 zeigt eine alternatives Verschalten einzelner LED-Gehäuse 1, hier dargestellt ist eine Parallelschaltung aus jeweils vier reihenverknüpften LED-Gehäusen 1. Wiederum entsprechen die LED-Gehäuse 1 einer der vorher beschriebenen Ausführungs- und/oder Weiterbildungsformen. Lediglich schematisch dargestellt ist die Gehäuseform mit den Halteelementen 5 und den Gehäuseanschlusselementen 6 aus den Figuren 1 bis 7. Charakteristisch für eine Parallelschaltung ist die Verbindung zweier Anodenanschlusselemente 6a, welches mit einem erfindungsgemäßen Adapterstück 17 ermöglicht wird. Das Adapterstück 17 ist in Figur 9a dargestellt und stellt eine Überbrückung 20 der beiden Adapteranschlüsse 18 dar. Eine weitere Aufgabe des Adapterstücks 17 ist die Funktion als Platzhalter beziehungsweise Abstandshalter zur besseren Wärmeableitung, falls ein gemeinsamer Kühlkörper für die zusammengeschalteten LED-Gehäuse verwendet wird.

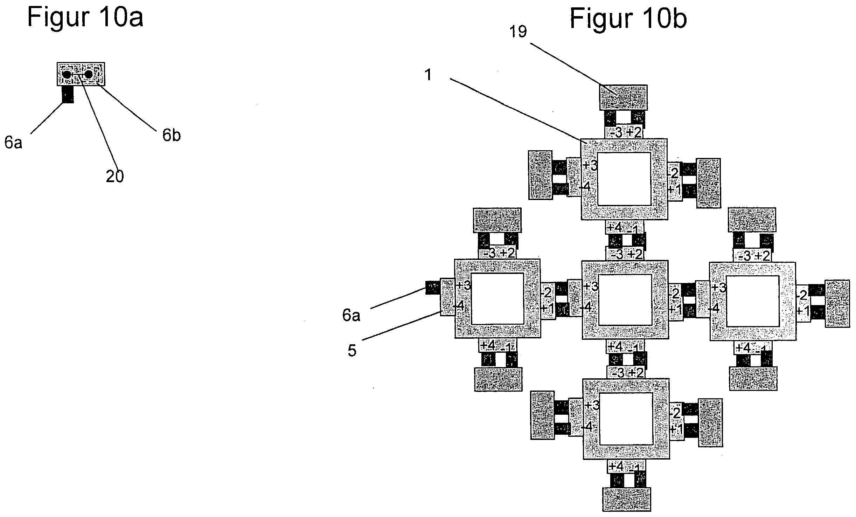

In Figur 10 ist eine weitere alternative Zusammenschaltung der beschriebenen LED-Gehäuse 1 dargestellt. Hier ist es eine sternförmige Verknüpfung von LED-Gehäusen 1, wobei jedes LED-Gehäuse mehrere Gehäuseanschlusselemente 6a und 6b aufweist, wodurch jedes einzelne Gehäuseanschlusselement 6a und 6b einen LED-Chip 4 innerhalb der Gehäusekavität 2 eines jeden LED-Gehäuses 1 ansteuert. Hierbei weist jedes LED-Gehäuse 1 nicht dargestellte LED-Chips 4 auf. Um alle LED-Chips 4 betreiben zu können, ist ein Brückenadapter 19 dargestellt in Figur 10a, der wiederum lediglich eine Überbrückung 20 zweier Anschlusselemente 6a und 6b darstellt. Er ist ein passgenaues Gegenstück des Gehäuseanschlusselementes 6a beziehungsweise 6b einer jeden Seite eines LED-Gehäuses 1 und weist ein Anodenanschlusselement 6a sowie ein Kathodenanschlusselement 6b auf.

Zum Betreiben der LED-Chips 4 dient der in Figur 10a dargestellte Brückenadapter zur Überbrückung des Kathodenmit dem Anodenanschluss der zu betreibenden LED. Zum Betrieb einer in Reihenschaltung verknüpften Mehrzahl von LEDs ist dieser wiederum ebenfalls einsetzbar und muss lediglich durch seine Formgebung und eventuell zur Belastung mit höheren Strömen ausgelegt sein.

Das Betreiben der LED-Chips 4 und der Versorgung jedes zu betreibenden Chips 4 mit Strom wird in die jeweilige Zusammenschaltung mittels Stromtreiberschaltkreisen angepasst. Diese Stromtreiberschaltkreise regeln einen stets konstanten und zum Betrieb notwendigen Betriebsstrom. Denkbar ist ein Zufügen und Entfernen von LED-Gehäusen 1 während des Betriebes, wobei ein Kurzschluss oder Überlastszenario durch die Stromtreiberschaltkreise entsprechend berücksichtigt und auszuschließen ist.

## Patentansprüche

1. LED-Gehäuse (1) mit einer Gehäusekavität (2), einem Trägerelement (3), mindestens einem LED-Chip (4), mindestens einem Halteelement (5) und zumindest einem Gehäuseanschlusselement (6), wobei:
- das Trägerelement (3) und der zumindest eine LED-Chip (4) innerhalb der Gehäusekavität (2) im LED-Gehäuse (1) angeordnet sind,
- der LED-Chip (4)auf einer ersten Oberseite des Trägerelements (3) angeordnet ist und das LED-Gehäuse (1) derart ausgeformt ist, dass:
- das zumindest eine Gehäuseanschlusselement (6) an einer Außenseite des LED-Gehäuses (1) angeordnet ist und eine elektrische Verbindung (8) zu dem zumindest einen LED-Chip (4) zum Betreiben dieses LED-Chips (4) aufweist und
- das LED-Gehäuse (1) mechanisch bedingt lösbar mit einem zweiten baugleichen LED-Gehäuse (1) verbindbar ist, **dadurch gekennzeichnet, dass**
- das LED-Gehäuse (1) mechanisch bedingt lösbar mit einem Träger mechanisch mittels des zumindest einem Halteelementes (5) verbindbar ist, wobei
- das Halteelement (5) ein in das LED-Gehäuse (1) eingebrachtes Loch ist, durch welches ein mechanisches Verbindeelement (14) geführt ist.

2. LED-Gehäuse (1) nach Anspruch 1,
wobei das mechanische Verbindeelement (14) eine Schraube oder ein Haltestift ist.

3. LED-Gehäuse (1) nach Anspruch 1 oder 2,
wobei das LED-Gehäuse (1) mechanisch bedingt lösbar mit einem baugleichen zweiten LED-Gehäuse (1) mechanisch und/oder elektrisch mittels des zumindest einem Halteelementes (5) verbindbar ist.

4. LED-Gehäuse (1) nach einem der vorhergehenden Ansprüche, wobei das LED-Gehäuse (1) ein Wärmeableitelement (7) auf zumindest einer zweiten, der ersten Oberseite gegenüberliegenden Seite des Trägerelements (3) aufweist.

5. LED-Gehäuse (1) nach einem der vorhergehenden Ansprüche, wobei das zumindest eine Halteelement (5) mehrteilig ist und zumindest ein Teil des Halteelements (5) das Gehäuseanschlusselement (6) beinhaltet.

6. LED-Gehäuse (1) nach einem der vorhergehenden Ansprüche, wobei das Gehäuseanschlusselement (6) mindestens einen Anodenanschlusselement (6a) und einen Kathodenanschlusselement (6b) aufweist, wobei das Anodenanschlusselement (6a) und das Kathodenanschlusselement (6b) ein mechanisches und/oder elektrisches Stecksystem bilden.

7. LED-Gehäuse (1) nach einem der vorhergehenden Ansprüche, wobei das LED-Gehäuse (1) SMT-montierbar ist und die Gehäuseanschlusselemente (6) über Steckverbindung und/oder Rastverbindung ansteuerbar sind.

8. LED-Gehäuse (1) nach einem der vorhergehenden Ansprüche, wobei das LED-Gehäuse (1) ein Steueranschlusselement (10) aufweist und dieses Steueranschlusselement (10) eine elektrische Verbindung (11) zu mindestens einem Steuerelement innerhalb der Gehäusekavität (2) aufweist, wobei jedes Steuerelement die Intensität der ausgesendeten elektromagnetischen Strahlung eines der LED-Chips (4) steuert.

9. LED-Gehäuse (1) nach einem der vorhergehenden Ansprüche, wobei das LED-Gehäuse (1) über das Gehäuseanschlusselement mittels Steckverbindung, Schneidklemmverbindung und/oder Käfigzugfeder elektrisch kontaktiert ist.

10. LED-Gehäuse (1) nach einem der vorhergehenden Ansprüche, wobei Teile des Halteelements das LED-Gehäuse (1) mittels Schraub-, Steck- und Rastverbindung (14) mechanisch mit baugleichen LED-Gehäusen (1) verbindbar machen.

11. LED-Gehäuse (1) nach Anspruch 1,
aufweisend
- ein Haltelement (5), das als Schraubenhalterung ausgebildet ist und das LED-Gehäuse (1) mittels zumindest eines als Schraube ausgebildeten Verbindeelement (14), das in das Haltelement (5) eingreift, mit einem Träger mechanisch verbindbar ist, und
- ein Gehäuseanschlusselement (6), mittels dem der LED-Chip (4) elektrisch kontaktierbar ist, wobei das Gehäuseanschlusselement seitlich am LED-Gehäuse (1) angeordnet ist.

12. LED-Kette aufweisend eine Vielzahl von LED-Gehäusen (1) gemäß zumindest einem der vorherigen Ansprüche,
bei der
- die LED-Gehäuse (1) an ihrer dem LED-Chip (4) abgewandten Unterseite auf einem Träger befestigt sind und
- zumindest zwei der LED-Gehäuse mittels je einem Gehäuseanschlusselement (6) elektrisch leitend miteinander verbunden sind, wobei zumindest ein Gehäuseanschlusselement (6) an jedem der LED-Gehäuse (1) seitlich angeordnet ist.

## Claims

1. LED housing (1) having a housing cavity (2), a carrier element (3), at least one LED chip (4), at least one retaining element (5) and at least one housing terminal element (6), wherein:
- the carrier element (3) and the at least one LED chip (4) are arranged inside the housing cavity (2) in the LED housing (1),
- the LED chip (4) is arranged on a first, upper side of the carrier element (3) and the LED housing (1) is shaped in such a way that:
- the at least one housing terminal element (6) is arranged on an outer side of the LED housing (1) and comprises an electrical connection (8) to the at least one LED chip (4) for operating this LED chip (4) and
- the LED housing (1) may be connected mechanically detachably to a second LED housing (1) of like construction, **characterized in that**
- the LED housing (1) may be mechanically connected mechanically detachably with a carrier by means of the at least one retaining element (5), wherein
- the retaining element (5) is a hole introduced into the LED housing (1), through which a mechanical connecting element (14) is guided.

2. LED housing (1) according to claim 1,
wherein the mechanical connecting element (14) is a screw or a retaining pin.

3. LED housing (1) according to claim 1 or claim 2,
wherein the LED housing (1) may be connected mechanically and/or electrically to a second LED housing (1) of like construction mechanically detachably by means of the at least one retaining element (5).

4. LED housing (1) according to one of the preceding claims, wherein the LED housing (1) comprises a heat dissipating element (7) on at least one second side of the carrier element (3) opposite the first, upper side.

5. LED housing (1) according to one of the preceding claims, wherein the at least one retaining element (5) is of multipart construction and at least one part of the retaining element (5) contains the housing terminal element (6).

6. LED housing (1) according to one of the preceding claims, wherein the housing terminal element (6) comprises at least one anode terminal element (6a) and one cathode terminal element (6b), wherein the anode terminal element (6a) and the cathode terminal element (6b) form a mechanical and/or electrical plug-and-socket system.

7. LED housing (1) according to one of the preceding claims, wherein the LED housing (1) may be SMT-mounted and the housing terminal elements (6) are controllable by way of plug-and-socket connection and/or latching connection.

8. LED housing (1) according to one of the preceding claims, wherein the LED housing (1) comprises a control terminal element (10) and this control terminal element (10) comprises an electrical connection (11) to at least one control element inside the housing cavity (2), wherein each control element controls the intensity of the electromagnetic radiation emitted by one of the LED chips (4).

9. LED housing (1) according to one of the preceding claims, wherein the LED housing (1) is electrically contacted via the housing terminal element by way of plug-and-socket connection, insulation displacement connection and/or cage clamp spring.

10. LED housing (1) according to any one of the preceding claims, wherein parts of the retaining element make the LED housing (1) mechanically connectable with LED housings (1) of like construction by way of screw, plug-and-socket and latching connection (14).

11. LED housing (1) according to claim 1, comprising
- a retaining element (5), which is configured as a screw holder, the LED housing (1) being connectable mechanically to a carrier by means of at least one connecting element (14), in the form of a screw, which engages in the retaining element (5), and
- a housing terminal element (6), by means of which the LED chip (4) may be electrically contacted, wherein the housing terminal element is arranged laterally on the LED housing (1).

12. LED chain comprising a multiplicity of LED housings (1) according to at least one of the preceding claims, in which
- the LED housings (1) are fastened to a carrier on their underside remote from the LED chip (4) and
- at least two of the LED housings are connected together electrically conductively by means of in each case one housing terminal element (6), wherein at least one housing terminal element (6) is arranged laterally on each of the LED housings (1).

## Revendications

1. Boîtier de LED (1) comprenant une cavité de boîtier (2), un élément de support (3), au moins une puce à LED (4), au moins un élément de maintien (5) et au moins un élément de raccordement de boîtier (6) :
- l'élément de support (3) et l'au moins une puce à LED (4) étant disposés dans le boîtier de LED (1) à l'intérieur de la cavité de boîtier (2),
- la puce à LED (4) étant disposée sur un premier côté supérieur de l'élément de support (3) et le boîtier de LED (1) étant formé de façon à ce que :
- l'au moins un élément de raccordement de boîtier (6) soit disposé sur un côté extérieur du boîtier de LED (1) et qu'il présente une liaison électrique (8) vers l'au moins une puce à LED (4) pour le fonctionnement de cette puce à LED (4) et
- le boîtier de LED (1) pouvant être relié mécaniquement, en étant amovible de manière mécanique restreinte, à un deuxième boîtier de LED (1) de construction identique, **caractérisé en ce que**
- le boîtier de LED (1) pouvant être relié mécaniquement, en étant amovible de manière mécanique restreinte, à un support au moyen de l'au moins un élément de maintien (5),
- l'élément de maintien (5) étant un trou placé dans le boîtier de LED (1), à travers lequel trou un élément de liaison (14) mécanique est guidé.

2. Boîtier de LED (1) selon la revendication 1,
l'élément de liaison (14) mécanique étant une vis ou une axe de retenu.

3. Boîtier de LED (1) selon la revendication 1 ou 2,
le boîtier de LED (1) pouvant être relié mécaniquement et/ou électriquement, en étant amovible de manière mécanique restreinte, à un deuxième boîtier de LED (1) de construction identique au moyen de l'au moins un élément de maintien (5).

4. Boîtier de LED (1) selon l'une quelconque des revendications précédentes, le boîtier de LED (1) présentant un élément dissipateur de chaleur (7) sur au moins un deuxième côté de l'élément de support (3), situé à l'opposé du premier côté supérieur.

5. Boîtier de LED (1) selon l'une quelconque des revendications précédentes, l'au moins un élément de maintien (5) étant réalisé en plusieurs parties et au moins une partie de l'élément de maintien (5) contenant l'élément de raccordement de boîtier (6).

6. Boîtier de LED (1) selon l'une quelconque des revendications précédentes, l'élément de raccordement de boîtier (6) présentant au moins un élément de raccordement d'anode (6a) et un élément de raccordement de cathode (6b), l'élément de raccordement d'anode (6a) et l'élément de raccordement de cathode (6b) formant un système d'enfichage mécanique et/ou électrique.

7. Boîtier de LED (1) selon l'une quelconque des revendications précédentes, le boîtier de LED (1) pouvant être monté par technique de montage en surface SMT et les éléments de raccordement de boîtier (6) pouvant être commandés par l'intermédiaire de liaison enfichable et/ou liaison d'encliquetage.

8. Boîtier de LED (1) selon l'une quelconque des revendications précédentes, le boîtier de LED (1) présentant un élément de connexion de commande (10) et cet élément de connexion de commande (10) présentant une liaison électrique (11) vers au moins un élément de commande situé à l'intérieur de la cavité de boîtier (2), chaque élément de commande commandant l'intensité du rayonnement électromagnétique émis d'une puce à LED (4).

9. Boîtier de LED (1) selon l'une quelconque des revendications précédentes, le boîtier de LED (1) étant mis en contact électrique au moyen de liaison enfichable, de connexion auto-dénudante et/ou de bloc de jonction à ressort par l'intermédiaire de l'élément de raccordement de boîtier.

10. Boîtier de LED (1) selon l'une quelconque des revendications précédentes, des parties de l'élément de maintien rendant le boîtier de LED (1) raccordable mécaniquement à des boîtiers de LED (1) de construction identique au moyen de liaison vissée, de liaison enfichable et de liaison encliquetable (14).

11. Boîtier de LED (1) selon la revendication 1, présentant
- un élément de maintien (5) qui est réalisé en tant que support de vis et le boîtier de LED (1) pouvant être relié mécaniquement à un support au moyen d'au moins un élément de liaison (14) réalisé comme vis, lequel élément de liaison a prise dans l'élément de maintien (5), et
- un élément de raccordement de boîtier (6) au moyen duquel la puce à LED (4) peut être mise en contact électrique, l'élément de raccordement de boîtier étant disposé latéralement sur le boîtier de LED (1).

12. Chaîne de LED présentant une pluralité de boîtiers de LED (1) selon au moins l'une quelconque des revendications précédentes, dans laquelle
- les boîtiers de LED (1) sont fixés sur un support sur leur côté inférieur détourné de la puce à LED (4) et
- au moins deux des boîtiers de LED sont reliés entre eux de manière électroconductrice au moyen de respectivement un élément de raccordement de boîtier (6), au moins un élément de raccordement de boîtier (6) étant disposé latéralement sur chacun des boîtiers de LED (1).
